# EUROPEAN PATENT APPLICATION

(11) **EP 3 742 873 A1**
(43) Date of publication of application: **25.11.2020**
(21) Application number: 19176177.4
(22) Date of filing: 23.05.2019
(51) Int. Cl.: H05K 5/06

(54) **ENCLOSURE OF AN ELECTRONIC CONTROL UNIT**

(71) Applicant: Aptiv Technologies Limited, St. Michael (BB)
(72) Inventor: Boron, Artur, 32-070 Czernichów (PL); Szostek, Grzegorz, 32-084 Morawica (PL); Melfried, Sebastian, 30-838 Kraków (PL)
(74) Representative: Manitz Finsterwald Patent- und Rechtsanwaltspartnerschaft mbB

(57) **Abstract**

An enclosure of an electronic control unit comprises a first enclosure member, a second enclosure member, and a sealing member. The first enclosure member and the second enclosure member are assembled under formation of a cavity for accommodation of a printed circuit board of the electronic control unit. The sealing member is arranged in a sealing channel formed between respective joining portions of the first enclosure member and the second enclosure member. At least one of the first enclosure member and the second enclosure member includes a filling duct guided from an outside of the enclosure to the sealing channel.

## Description

### FIELD

The present disclosure relates to an enclosure of an electronic control unit comprising a first enclosure member, a second enclosure member, and a sealing member, wherein the first enclosure member and the second enclosure member are assembled under formation of a cavity for accommodation of a printed circuit board of the electronic control unit. The disclosure further relates to an electronic control unit comprising a printed circuit board and an enclosure accommodating the printed circuit board. Further, the disclosure relates to a method for manufacturing an electronic control unit.

### BACKGROUND

Electronic control units, also called ECUs, are used as embedded systems in a variety of devices, machines and vehicles. For example, electronic control units may be installed in automobiles, ships, agricultural machines and the like. In operation, electronic control units may dissipate a considerable amount of thermal energy. Moreover, electronic control units are often used in engine compartments or similar regions exhibiting harsh environmental conditions. Therefore, the enclosure of an electronic control unit should be stable, thermally resistant and moisture-proof. Screws and/or metal clips may be used to hold the enclosure members of an electronic control unit together.

However, the provision of screws and/or clips raises the fabrication costs and impedes an automated assembly. If screws are disposed outside of the area of the printed circuit board, the enclosure must be considerably bigger than the printed circuit board. If screws are guided through the printed circuit board, only a restricted area of the printed circuit board can be used for arranging electronic circuits.

Accordingly, there is a need to provide an electronic control unit, an enclosure of an electronic control unit and a method for manufacturing an electronic control unit of the above referenced kind by which the aforementioned problem is overcome. In particular, a reliable and moisture-proof fixation of the enclosure members to one another should be achievable without the use of screws and clips.

### SUMMARY

The present disclosure provides an enclosure of an electronic control unit, an electronic control unit and a method for manufacturing an electronic control unit according to the independent claims. Embodiments are given in the dependent claims, the description and the drawings.

In one aspect, the present disclosure is directed at an enclosure of an electronic control unit comprising a first enclosure member, a second enclosure member, and a sealing member, wherein the first enclosure member and the second enclosure member are assembled under formation of a cavity for accommodation of a printed circuit board of the electronic control unit and the sealing member is arranged in a sealing channel formed between respective joining portions of the first enclosure member and the second enclosure member, and wherein at least one of the first enclosure member and the second enclosure member includes a filling duct guided from an outside of the enclosure to the sealing channel.

The sealing member forms a gasket locking and sealing the enclosure members. Consequently, additional fastening means such as screws and clips can be dispensed with. Due to the sealing channel, which is a guide for a liquid sealing material, it is not necessary to provide a two-dimensional positioning system for moving a dispenser head along a predefined sealing track. Instead, the sealing channel may be filled with the liquid sealing material by means of a stationary dispenser head positioned at the filling duct. Moreover, the sealing channel may be filled after the enclosure members have been assembled. Thus, it is easy to automatically assemble an enclosure as described herein.

According to an embodiment, the first enclosure member is a plate-like base member and the second enclosure member is a hood-like or half-shell-like cover member. The printed circuit board may be put into the half-shell-like cover member and clamped between the plate-like base member and the half-shell-like cover member.

According to another embodiment, the joining portion of the first enclosure member includes a groove which is covered by the joining portion of the second enclosure member, or vice versa, wherein the sealing channel is formed by the covered groove. Such a construction is particularly simple. The joining portion of the first enclosure member and the joining portion of the second enclosure member may include respective grooves which are located opposite to each other when the enclosure members are assembled.

According to an embodiment, the sealing channel extends along a circumferential edge portion of the first enclosure member and/or of the second enclosure member. This ensures a thorough sealing along the entire periphery of the enclosure. The enclosure may comprise at least one opening for a connector member, wherein the sealing channel extends around the opening. Thus, the junction between the connector member and the enclosure is sealed and locked by the sealing member. An additional sealing member for sealing the connector member can be dispensed with. According to a further embodiment, the sealing member comprises at least one annular portion surrounding a connector member when the electronic control unit is assembled.

The sealing channel may be filled with a dried or cured liquid sealing material. This means that the sealing member may be made of a sealing material which is at least essentially solid, but has originally been liquid. The solidification of the sealing material may be the consequence of a specific curing step. However, in certain instances, the originally liquid sealing material may harden over time, without any specific curing measures. The sealing material may comprise a silicone-based sealing material. Alternatively, the sealing material may comprise a rubber-based sealing material. In order to configure the enclosure as a closed Faraday cage and to enhance the shielding properties of the enclosure, the sealing channel may be filled with an electrically conductive sealing material. Problems in terms of electromagnetic compatibility (EMC) are thus reduced.

The first enclosure member and the second enclosure member may be fixed together exclusively by an adhesive force imparted by the sealing member. In other words, the first enclosure member and the second enclosure member may be fixed together without any additional fastening members such as screws, rivets, clips, clamps or the like. This provides for a reduction of costs and equally of required installation space.

In accordance with another embodiment, the enclosure includes at least one inspection opening in fluid connection with the sealing channel. The quality of the sealing member within the sealing channel may be estimated by visual inspection through the inspection opening. Moreover, in particular if the inspection opening is located at an end portion of the sealing channel, a completion of the filling process may be determined as soon as the sealing member is visible through the inspection opening. The inspection opening may also serve for performing an overfilling of the sealing channel, thus ensuring a complete charging of the sealing channel with sealing material. If several inspection openings at different positions of the sealing channel are provided, an operator can see which part of the sealing channel is already filled.

The at least one inspection opening may be located in a corner portion of the enclosure. The enclosure may have a box-like shape, wherein the at least one inspection opening and an inlet of the filling duct are located on opposite faces of the box-like enclosure. Consequently, the filling may be carried out from below, with redundant sealing material emerging at the top of the enclosure. An unwanted dripping of sealing material is thus avoided.

According to an embodiment, the first enclosure member and the second enclosure member are made of metal. This provides for a sufficient thermal stability for a use in an engine compartment. For example, the first enclosure member may be a die cast part or a cold forge part and the second enclosure member may be a sheet metal part, or vice versa. If the application requirements regarding thermal stability are less strict, the first enclosure member and the second enclosure member may be made of plastic.

The enclosure may further comprise one or more of the following features:
The joining portion of the first enclosure member may include a groove which is covered by the joining portion of the second enclosure member, or vice versa, wherein the sealing channel is formed by the covered groove. The sealing channel may extend along a circumferential edge portion of the first enclosure member and/or of the second enclosure member. The sealing channel may be filled with a cured liquid sealing material. The first enclosure member and the second enclosure member may be fixed together exclusively by an adhesive force imparted by the sealing member. The enclosure may include at least one inspection opening in fluid connection with the sealing channel. The at least one inspection opening may be located in a corner portion of the enclosure. The first enclosure member and the second enclosure member may be made of metal.

In another aspect, the present disclosure is directed at an electronic control unit comprising a printed circuit board and an enclosure accommodating the printed circuit board, wherein the enclosure comprises a first enclosure member, a second enclosure member, and a sealing member, wherein the first enclosure member and the second enclosure member are assembled under formation of a cavity for accommodation of a printed circuit board of the electronic control unit and the sealing member is arranged in a sealing channel formed between respective joining portions of the first enclosure member and the second enclosure member, and wherein at least one of the first enclosure member and the second enclosure member includes a filling duct guided from an outside of the enclosure to the sealing channel.

The electronic control unit may be configured as an embedded system for a motor vehicle, such as an engine control module (ECM) for an internal combustion engine. The printed circuit board may include integrated circuits such as an application specific integrated circuit (ASIC).

According to an embodiment, the printed circuit board carries at least one connector which is guided through a connector opening of the enclosure and wherein a connector sealing channel is formed between the first enclosure member and the connector and/or between the second enclosure member and the connector.

In another aspect, the present disclosure is directed at a method for manufacturing an electronic control unit comprising the steps of providing a first enclosure member, a second enclosure member and a printed circuit board including electronic components of the electronic control unit, attaching the printed circuit board to the first enclosure member or to the second enclosure member, assembling the first enclosure member and the second enclosure member so as to form an enclosure accommodating the printed circuit board, wherein a sealing channel is formed between respective joining portions of the first enclosure member and the second enclosure member, and filling the sealing channel with a liquid sealing material after the step of assembling the first enclosure member and the second enclosure member.

Due to this solution it is not necessary to apply the sealing material onto one of the enclosure members by means of a complex positioning device. Thus, the disclosed manufacturing method is quick and simple.

According to an embodiment, the step of filling the sealing channel with a liquid sealing material comprises feeding the liquid sealing material to a filling duct guided from an outside of the enclosure to the sealing channel. The feeding of the liquid sealing material to the filling duct may be carried out by means of a controllable dispenser having a nozzle. During the step of feeding the liquid sealing material to the filling duct, the enclosure comprising the assembled enclosure members may be held in a fixture.

In accordance with another embodiment, the method comprises curing the liquid sealing material in the sealing channel. Dependent on the type of the sealing material, the sealing material may be cured thermally, chemically or by means of optical radiation. After the solidification of the sealing material, the enclosure members are sealed and locked.

According to a further embodiment, the enclosure includes an inspection opening in fluid connection with the sealing channel and the filling of the sealing channel is monitored using the inspection opening. The monitoring may be carried out by means of a camera system. The camera system may comprise an electronic image processing system.

The filling of the sealing channel with a liquid sealing material may be carried out until sealing material leaks from the inspection opening. By means of such an "overfilling", it is ensured that the sealing channel is thoroughly filled.

The method may further comprise one or more of the following features:
The step of filling the sealing channel with a liquid sealing material may comprise feeding the liquid sealing material to a filling duct guided from an outside of the enclosure to the sealing channel. The liquid sealing material may be cured in the sealing channel. The enclosure may include an inspection opening in fluid connection with the sealing channel, wherein the filling of the sealing channel is monitored using the inspection opening. The filling of the sealing channel with a liquid sealing material may be carried out until sealing material leaks from the inspection opening.

### DRAWINGS

Exemplary embodiments and functions of the present disclosure are described herein in conjunction with the following drawings:
- Fig. 1: depicts an exemplary electronic control unit in an exploded view.
- Fig. 2: depicts an exemplary electronic control unit in a partially sectional view.
- Fig. 3: depicts an exemplary electronic control unit in a perspective view from below.
- Fig. 4: depicts a connector portion of an exemplary electronic control unit in an enlarged partial view.
- Fig. 5: depicts a flow diagram of an exemplary method for manufacturing an electronic control unit.

### DETAILED DESCRIPTION

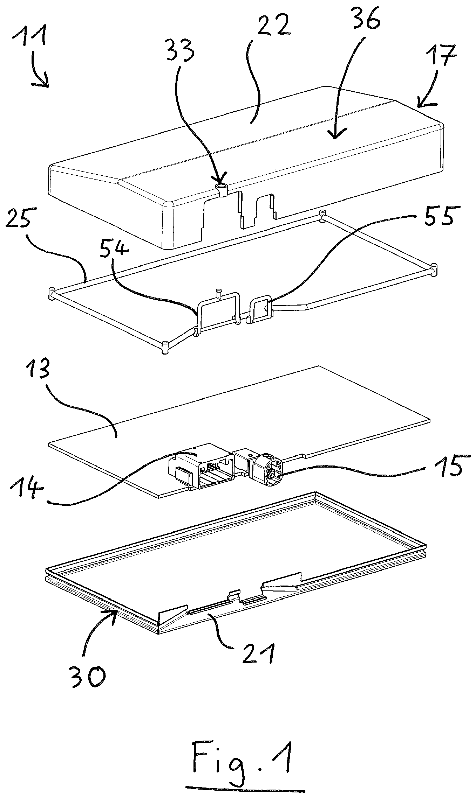

In Fig. 1, there is shown an exemplary electronic control unit 11. The electronic control unit 11 comprises a printed circuit board 13 carrying integrated circuits, not shown, as well as two connector members 14, 15 for connecting the electronic control unit 11 to a power source and to further electronic devices such as actors, sensors and/or a superordinate control unit. The printed circuit board 13 is accommodated in an enclosure 17 which comprises a first enclosure member 21 and a second enclosure member 22, both of which are made of metal. The first enclosure member 21 is a plate-like base member, whereas the second enclosure member 22 is a hood-like cover member. The first enclosure member 21 and the second enclosure member 22 are sealed and locked by means of a sealing member 25 made of a dried or cured silicone-based sealing material.

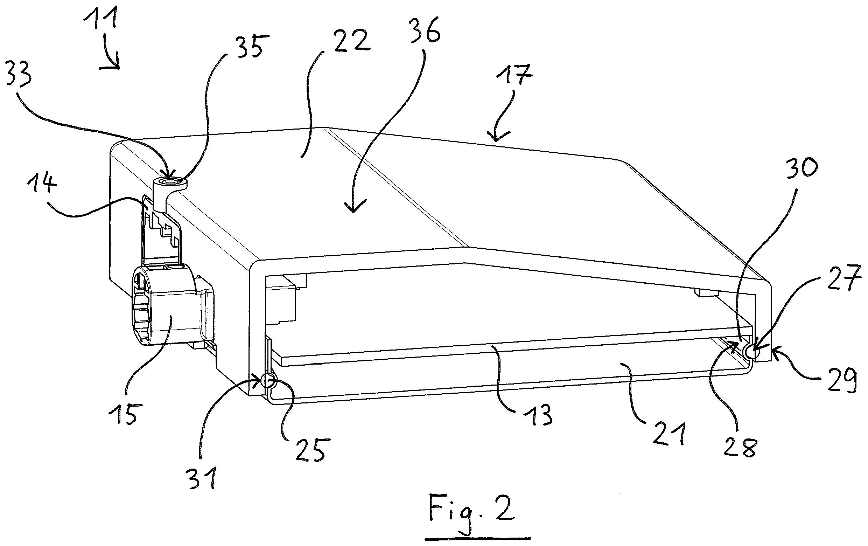

Fig. 2 shows a sealing channel 27 formed between overlapping joining portions 28, 29 of the first enclosure member 21 and the second enclosure member 22. The sealing channel 27 extends along a circumferential edge portion of the first enclosure member 21 and of the second enclosure member 22.

The joining portion 28 of the first enclosure member 21 includes a groove 30 which is covered by the joining portion 29 of the second enclosure member 22. The joining portion 29 of the second enclosure member 22 equally includes a groove 31. In an assembled state of the enclosure 17, the groove 30 formed in the first enclosure member 21 is located opposite to the groove 31 of the second enclosure member 22. The sealing channel 27 is formed between the opposing grooves 30, 31. It has to be noted that the sealing channel could alternatively be formed by a single groove which is covered by a flat joining portion. The sealing member 25 is arranged in the sealing channel 27.

A filling duct 33 is guided from an outside of the enclosure 17 to the sealing channel 27. As shown, the filling duct 33 includes an inlet 35 which is located on a top face 36 of the enclosure 17. The position of the filling duct 33 is close to the connector 14.

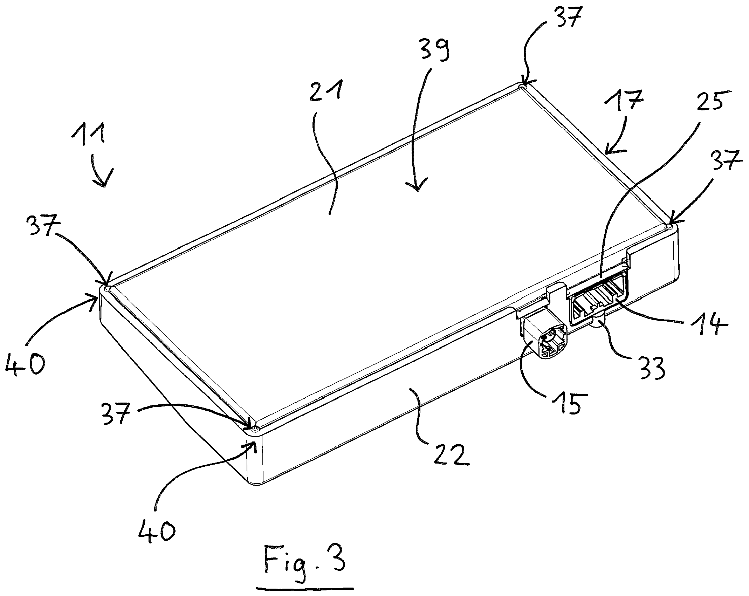

Fig. 3 depicts the exemplary electronic control unit 11 in a perspective view from below. Four inspection openings 37 communicating with the sealing channel 27 are disposed on the bottom face 39 of the enclosure 17. The enclosure 17 has a box-like shape, wherein the four inspection openings 37 are located at corners 40 of the box-like enclosure 17.

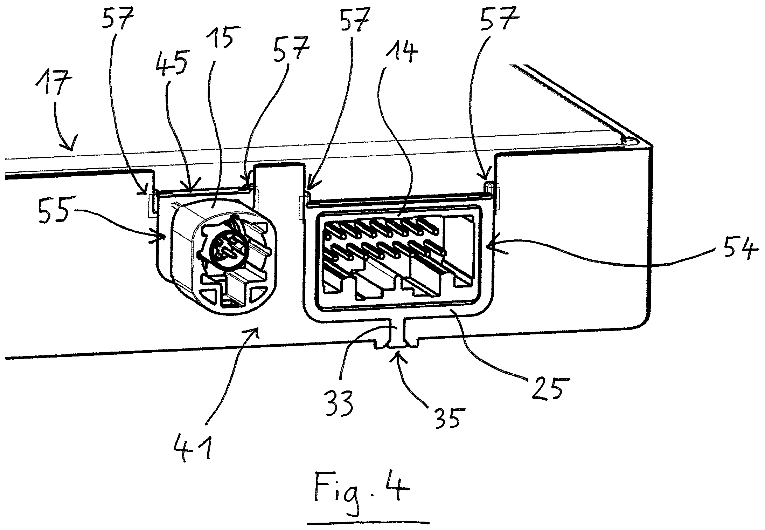

Fig. 4 depicts a connector portion 41 of the electronic control unit 11. The connector members 14, 15 are guided through respective connector openings 44, 45 formed in the enclosure 17. The sealing member 25 comprises annular portions 54, 55 extending around the connector members 14, 15. Consequently, the connector members 14, 15 are sealed with respect to the enclosure 17 by means of the annular portions 54, 55. Four additional inspection openings 57 communicating with the sealing channel 27 are arranged at the annular portions 54, 55.

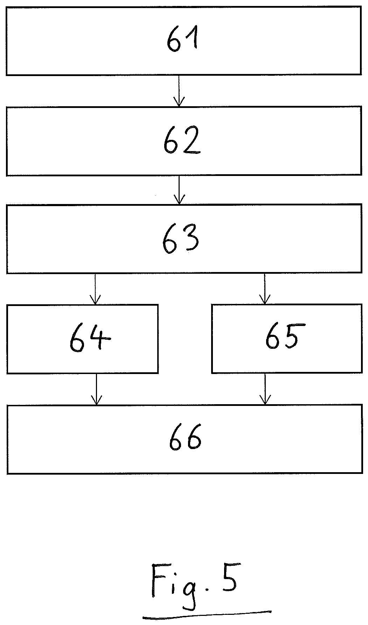

Fig. 5 is a flow diagram depicting an exemplary method for manufacturing the electronic control unit 11. In a step 61, the printed circuit board 13 is attached to the second enclosure member 22, for example by arranging the printed circuit board 13 in a cavity defined by the second enclosure member 22. Then, in a step 62, the first enclosure member 21 and the second enclosure member 22 are assembled so as to cover the cavity by the first enclosure member 22 and to form the sealing channel 27. As a result, the printed circuit board 13 is accommodated in an enclosure 17 formed by the first enclosure member 21 and the second enclosure member 22. The printed circuit board 13 may be fixed within the enclosure 17 by clamping, sticking and/or screwing. Specifically, the printed circuit board 13 may be clamped between the first enclosure member 21 and the second enclosure member 22.

In a step 63, the enclosure 17 is held by means of a fixture, not shown, with the bottom face 39 facing upwards. By means of a dispenser, also not shown, a curable liquid sealing material is fed to the filling duct 33 in a step 64 to fill the sealing channel 27 formed between the joining portions 28, 29 of the first enclosure member 21 and the second enclosure member 22 with the curable liquid sealing material. A nozzle of the dispenser may be held stationary at the inlet 35 of the filling duct 33. A moving arm for positioning the dispenser is not necessary. Also, a pre-clipping is not required.

During the step of filling the sealing channel 27 with the curable liquid sealing material, the inspection openings 37, 57 are monitored by means of an electronic camera system (step 65). Once the liquid sealing material leaks from the inspection openings 37, 57, the feeding of the liquid sealing material to the filling duct 33 is stopped. The liquid sealing material in the sealing channel 27 is then cured in a step 66 to lock and seal the enclosure members 21, 22.

The cross-sectional area of the sealing channel 27 is adapted to the density and the viscosity of the liquid sealing material in order to allow for a smooth filling. For example, the average diameter of the sealing channel 27 may range from 0.5 mm to 10 mm.

Since the first enclosure member 21 and the second enclosure member 22 are fixed together exclusively by the adhesive force imparted by the sealing member 25, no screws are required. Due to the sealing member 25, the disclosed enclosure 17 may achieve a high level of protection according to IEC standard 60529, for example an IP67 level.

### Reference numeral list

- 11: electronic control unit
- 13: printed circuit board
- 14: connector member
- 15: connector member
- 17: enclosure
- 21: first enclosure member
- 22: second enclosure member
- 25: sealing member
- 27: sealing channel
- 28: joining portion of the first enclosure member
- 29: joining portion of the second enclosure member
- 30: groove formed in the first enclosure member
- 31: groove formed in the second enclosure member
- 33: filling duct
- 35: inlet
- 37: inspection opening
- 39: bottom face
- 40: corner
- 41: connector portion
- 44: connector opening
- 45: connector opening
- 54: annular portion
- 55: annular portion
- 57: further inspection opening
- 61-66: manufacturing steps

## Claims

1. Enclosure (17) of an electronic control unit (11), comprising:
- a first enclosure member (21),
- a second enclosure member (22), and
- a sealing member (25),
wherein the first enclosure member (21) and the second enclosure member (22) are assembled under formation of a cavity for accommodation of a printed circuit board (13) of the electronic control unit (11) and the sealing member (25) is arranged in a sealing channel (27) formed between respective joining portions (28, 29) of the first enclosure member (21) and the second enclosure member (22), and wherein at least one of the first enclosure member (21) and the second enclosure member (22) includes a filling duct (33) guided from an outside of the enclosure (17) to the sealing channel (27).

2. Enclosure according to claim 1, wherein the joining portion (28) of the first enclosure member (21) includes a groove (30) which is covered by the joining portion (19) of the second enclosure member (22), or vice versa, wherein the sealing channel (27) is formed by the covered groove (30).

3. Enclosure according to claim 1 or claim 2, wherein the sealing channel (27) extends along a circumferential edge portion of the first enclosure member (21) and/or of the second enclosure member (22).

4. Enclosure according to anyone of the preceding claims, wherein the sealing channel (27) is filled with a dried or cured liquid sealing material.

5. Enclosure according to anyone of the preceding claims, wherein the first enclosure member (21) and the second enclosure member (22) are fixed together exclusively by an adhesive force imparted by the sealing member (25).

6. Enclosure according to anyone of the preceding claims, wherein the enclosure (17) includes at least one inspection opening (37, 57) in fluid connection with the sealing channel (27).

7. Enclosure according to claim 6, wherein the at least one inspection opening (37) is located in a corner portion (40) of the enclosure (17).

8. Enclosure according to anyone of the preceding claims, wherein the first enclosure member (21) and the second enclosure member (22) are made of metal.

9. Electronic control unit (11) comprising a printed circuit board (13) and an enclosure (17) accommodating the printed circuit board (13), wherein the enclosure (17) is configured according to anyone of the preceding claims.

10. Electronic control unit (11) according to claim 9, wherein the printed circuit board (13) carries at least one connector (14, 15) which is guided through a connector opening (44, 45) of the enclosure (17) and wherein a connector sealing channel is formed between the first enclosure member (21) and the connector (14, 15) and/or between the second enclosure member (22) and the connector (14, 15).

11. Method for manufacturing an electronic control unit (11), for example an electronic control unit according to anyone of the preceding claims 9 and 10, comprising the steps of
- providing a first enclosure member (21), a second enclosure member (22) and a printed circuit board (13) including electronic components of the electronic control unit (11),
- attaching (61) the printed circuit board (13) to the first enclosure member (21) or to the second enclosure member (22),
- assembling (62) the first enclosure member (21) and the second enclosure member (22) so as to form an enclosure (17) accommodating the printed circuit board (13), wherein a sealing channel (27) is formed between respective joining portions (28, 29) of the first enclosure member (21) and the second enclosure member (22), and
- filling (64) the sealing channel (27) with a liquid sealing material after the step of assembling the first enclosure member (21) and the second enclosure member (22).

12. Method according to claim 11, wherein the step of filling the sealing channel (27) with a liquid sealing material comprises feeding the liquid sealing material to a filling duct (33) guided from an outside of the enclosure (17) to the sealing channel (27).

13. Method according to anyone of the preceding claims 11 and 12, wherein the method comprises curing (66) the liquid sealing material in the sealing channel (27).

14. Method according to anyone of the preceding claims 11 to 13, wherein the enclosure (17) includes an inspection opening (37, 57) in fluid connection with the sealing channel (27) and the filling of the sealing channel (27) is monitored (65) using the inspection opening (37, 57).

15. Method according to claim 14, wherein the filling of the sealing channel (27) with a liquid sealing material is carried out until sealing material leaks from the inspection opening (37, 57).
